# EUROPÄISCHE PATENTSCHRIFT

(11) **EP 1 538 236 B1**
(45) Veröffentlichungstag und Bekanntmachung des Hinweises auf die Patenterteilung: **21.05.2008**
(21) Anmeldenummer: 04027863.2
(22) Anmeldetag: 24.11.2004
(51) Int. Cl.: C23C 16/458, C23C 14/50, C23C 14/56

(54) **Substratträger**
Substrate support
Support de substrat

(30) Priorität: 28.11.2003 DE 10355679
(43) Veröffentlichungstag der Anmeldung: 08.06.2005
(73) Patentinhaber: Singulus Technologies AG, 63796 Kahl/Main (DE)
(72) Erfinder: Kempf, Stefan, 63755 Alzenau (DE); Merz, Thomas, 63739 Aschaffenburg (DE); Runkel, Steffen, Dr., 63584 Gründau-Lieblos (DE)
(74) Vertreter: Vossius & Partner

(56) Entgegenhaltungen:
- DE-A1- 2 723 284
- DE-A1- 4 446 179
- US-A- 4 182 265
- PATENT ABSTRACTS OF JAPAN Bd. 014, Nr. 488 (M-1039), 24. Oktober 1990 (1990-10-24) & JP 02 198787 A (NIPPEI TOYAMA CORP; others: 01), 7. August 1990 (1990-08-07)
- PATENT ABSTRACTS OF JAPAN Bd. 2003, Nr. 02, 5. Februar 2003 (2003-02-05) & JP 2002 307343 A (MATSUSHITA ELECTRIC IND CO LTD), 23. Oktober 2002 (2002-10-23)

## Beschreibung

Die Erfindung betrifft ein Substratträger-Adapter-System, wobei an dem Substratträger als Adapter Einrichtungen vorgesehen sind, um den Substratträger zu halten und/oder zu greifen. Der Substratträger ist als ein in Axialrichtung offener Ring ausgebildet, der mindestens ein Substrat trägt und für die einseitige oder beidseitige Behandlung des Substrats geeignet ist.

Im Stand der Technik besteht das Problem, Substrate in unterschiedlicher Form und Größe in einer Anlage zu behandeln (Handling). Dabei kommen unterschiedliche Substratträger mit unterschiedlichen Anpassungen an Halterungssysteme für die Substratträger zum Einsatz.

Der Erfindung liegt die Aufgabe zugrunde, ein Substratträger-Adapter-System zur Verfügung zu stellen, das die Halterung und den Transport von in Form und Größe unterschiedlichen Substraten in einer bzw. durch eine Anlage ermöglicht und vielseitig einsetzbar ist. Diese Aufgabe wird mit den Merkmalen der Patentansprüche gelöst.

Bei der Lösung geht die Erfindung von folgenden Grundgedanken aus.

Der Substratträger ist in Form eines Ringes ausgebildet, der einen Innenraum umschließt und an seinem Außenumfang Einrichtungen für den Eingriff einer Halte- und/oder Greifvorrichtung aufweist. Der Innenraum ist frei definierbar und kann Haltevorrichtungen für verschiedene Substrate aufnehmen, die einseitig oder beidseitig behandelt werden können, da der Innenraum nur durch die ringförmige Außenwand abgeschlossen ist. Die Außenwand ist geometrisch definiert und besteht aus zwei umlaufenden konkaven Nuten, die symmetrisch zur Mittelebene des Rings angeordnet sind und aus einem umlaufenden konvexen Vorsprung, durch dessen Scheitelpunkt die Mittelebene des Substratträgerringes hindurch geht. Die Halterung des Substratträgers erfolgt durch Rollen, die entweder in die Nuten eingreifen, oder in Verbindung mit einem Anschlag auf dem Vorsprung gefedert aufsitzen. Desweiteren kann der Substratträger an dem Vorsprung durch die Flächen einer V-förmigen Ringnut gehalten werden.

Durch die Erfindung wird eine einheitliche Verbindungsstelle (Adapter) zu unterschiedlichen Substraten zur Verfügung gestellt, die eine Vielzahl von Funktionen übernehmen kann. Bei Beschichtungsprozessen dient der Substratring dazu, andere Maschinenteile vor einer ungewollten Beschichtung zu schützen (Maskierung, Abschirmung). Bei Sputterbeschichtungsprozessen kann die Wand des Substratringes als Anodenfläche für den Prozeß dienen. Die Wand des Substratringes kann zusätzliche Bauteile (z.B. Transponder zur Identifizierung des Halteringes oder ähnliches) tragen. Das Substrat ist im Innenraum des Substratträgerringes gut vor Beschädigungen geschützt. Neben dem Einsatz des Substratträgers bei Beschichtungsprozessen kann er auch bei vor- oder nachgeschalteten Prozessen z.B. der Reinigung zum Einsatz kommen. Insbesondere kann die Erfindung bei der Behandlung von z.B. CDs, DVDs, optischen Linsen oder Brillengläsern zum Einsatz kommen.

Im folgenden wird die Erfindung anhand der Zeichnung näher erläutert. Es zeigen:
- Fig. 1: einen Querschnitt durch den erfindungsgemäßen Substratträger,
- Fig. 2: einen Querschnitt der Außenwand des erfindungsgemäßen Substratträgers im Eingriff mit einer Haltevorrichtung,
- Fig. 3: einen Querschnitt der Außenwand des erfindungsgemäßen Substratträgers im Eingriff mit zwei Greifvorrichtungen, und
- Fig.4: einen Querschnitt der Wand des erfindungsgemäßen Substratträgers im Eingriff mit einer weiteren Greifvorrichtung.

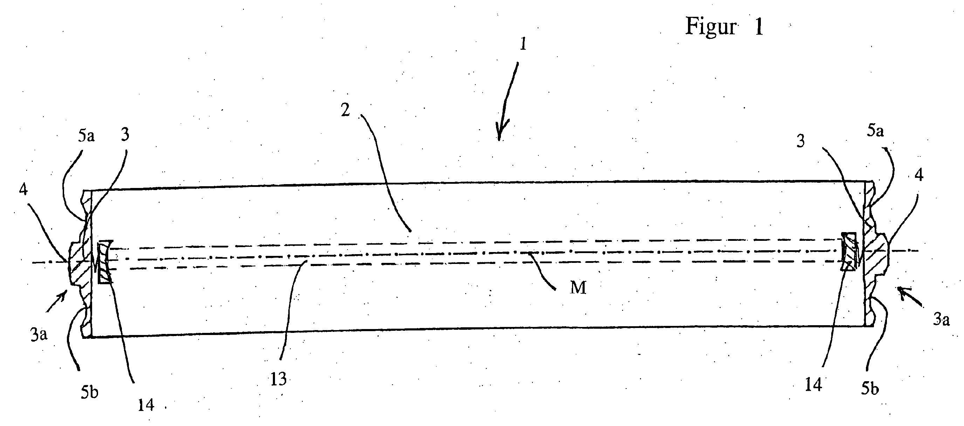

Figur 1 zeigt einen Querschnitt durch den erfindungsgemäßen Substratträger 1. Der Substratträger weist einen Innenraum 2 zur Aufnahme von mindestens einem Substrat 13 auf. Der Innenraum ist von einer ringförmigen Wand 3 umgeben, die sich senkrecht zur Mittelebene M des Substratträgers erstreckt. Im Innenraum 2, der frei definierbar ist, können Einrichtungen 14 zum Halten von einem oder mehreren Substraten vorgesehen sein, die z.B. federnd mit der Wand 3 verbunden sind, wobei das Substrat 13 (gestrichelt dargestellt) vorzugsweise symmetrisch zur Mittelebene M angeordnet ist. Die Halteinrichtungen 14 sind nur schematisch dargestellt, da deren Form jeweils an das einzusetzende Substrat anzupassen ist.

Da der Innenraum 2 senkrecht zur Mittelebene M beidseitig offen ist, können sowohl einseitige als auch zweiseitige Bearbeitungsprozesse von Substraten durchgeführt werden. Am Außenumfang 3a der Wand 3 ist ein umlaufender konvexer, zur Mittelebene M symmetrischer Vorsprung 4 angeordnet, dessen Scheitelpunkt in der Mittelebene M liegt. Außerdem sind auf der einen und der anderen Seite bezüglich der Mittelebene, d.h. in der Zeichnung oberhalb und unterhalb der Mittelebene, und symmetrisch zu ihr zwei umlaufende konkave Nuten 5a und 5b angeordnet. Der Vorsprung 4 und die Nuten 5a und 5b sind für den Eingriff mit mindestens einer Halte- und/oder Greifvorrichtung vorgesehen, die den Substratträger entweder passiv hält oder ihn aktiv greift, um den Substratträgerring zu transportieren bzw. an andere Halte- und Greifvorrichtungen zu übergeben.

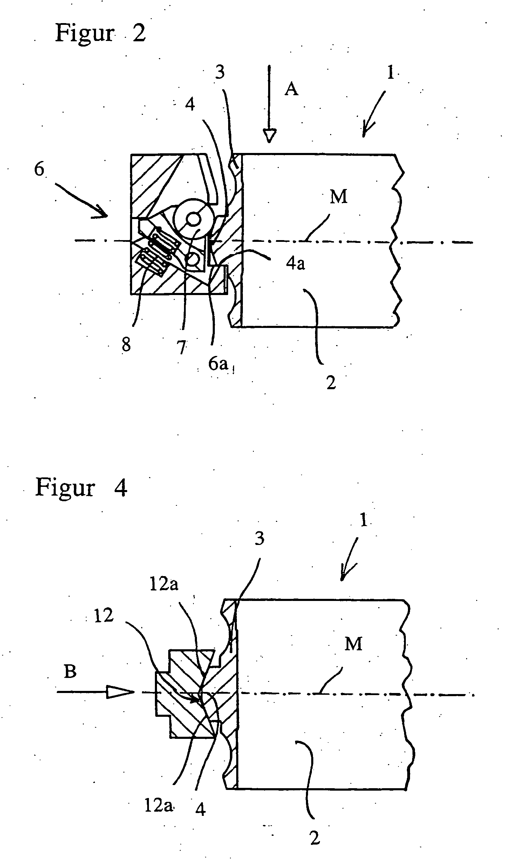

Figur 2 zeigt die Halterung des Substratträgers 1 in einer passiven Haltevorrichtung (gefederte Spannrolle) 6; eine Rolle 7 wird durch eine Feder 8 gegen den Vorsprung 4 (in der Zeichnung) oberhalb der Mittelebene M gedrückt, und eine Anschlagsfläche 6a der Haltevorrichtung 6 dient als Anschlag, auf dem der Vorsprung 4 mit seiner Fläche 4a unterhalb der Mittelebene M aufsitzt. In diese passive Haltevorrichtung 6 wird der Substratträger 1 in Richtung des Pfeiles A an der Rolle 7 gegen die Federkraft der Feder 8 rollend oder gleitend bis zum Anschlag auf der Fläche 6a durch Druck eingeführt. Durch die gerade Anschlagfläche 4a des Vorsprungs 4 wird eine definierte Höhenposition des Substratträgers gewährleistet. Die gefederte Rolle hält den Substratträger mit einer definierten Kraft. Zusätzlich kann der Substratträger zentriert werden, wenn am Umfang des Ringes mindestens drei oder mehrere Haltevorrichtungen 6 mit den gefederten Spannrollen angeordnet sind. Außer der Haltevorrichtung 6 können auch andere formschlüssige Haltesysteme verwendet werden, die in Eingriff mit der strukturierten Oberfläche der Wand 3 des Substratträgers gebracht werden können.

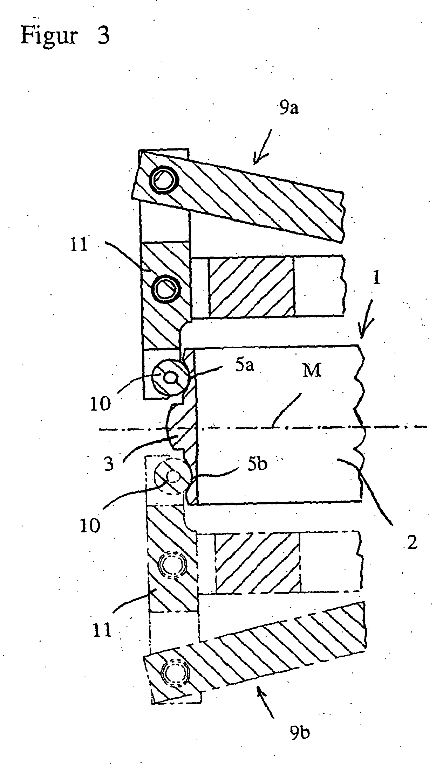

Figur 3 zeigt einen Querschnitt durch die Außenwand 3 des Substratträger-Adapter-Systems 1 im Eingriff mit einer ersten und zweiten Greifvorrichtung mit Greifeinrichtungen 9a bzw. 9b. Die Greifeinrichtungen weisen je einen Greiferfinger 11 auf, an dessen Ende eine Rolle 10 angeordnet ist, die jeweils mit einer Nut 5a bzw. 5b des Substratträgers 1 in Eingriff ist. Der Radius der Nut 5a, 5b ist etwas größer als der Radius der Rolle 10, so daß senkrecht zur Achse der Rolle 10 eine selbsttätige Ausrichtung des Substratträgers 1 erfolgt (die Rolle 10 strebt dem tiefsten Punkt der Nut 5a, 5b zu). Durch diesen Effekt und eine Zentrierwirkung, wenn drei oder mehr Greifeinrichtungen verwendet werden, kann die zulässige Positionstoleranz eines Greifssystems relativ groß sein, und trotzdem noch ein sicheres Greifen gewährleisten.

In Figur 3 ist ein Fall dargestellt, wobei eine Übergabe von der ersten Greifvorrichtung an die zweite Greifvorrichtung erfolgt. Der Substratträger wird noch durch die Greifeinrichtung 9a der ersten Greifvorrichtung in der Nut 5a gehalten, während die Greifeinrichtung 9b der zweiten Greifvorrichtung bereits in die Nut 5b eingegriffen hat. Nach dem Entfernen der ersten Greifvorrichtung (nicht dargestellt) von dem Substratträger 1 kann dieser durch die zweite Greifvorrichtung weiter transportiert werden.

Figur 4 zeigt einen Querschnitt durch die Wand 3 des Substratträger-Adapter-Systems 1 im Eingriff mit einer alternativen Greifvorrichtung, die zwei, drei oder mehr Greifeinrichtungen mit jeweils einer V-förmigen Ringnut 12 aufweist, die mit ihrer der Außenwand zugewandten Fläche 12a den konvexen Vorsprung 4 oberhalb und unterhalb der Mittelebene M tangiert. Die Ringnut 12 wird in Pfeilrichtung B an den Vorsprung 4 herangefahren. Auch bei dieser Greifvorrichtung richtet sich der Substratträger 1 senkrecht zur Andruckrichtung B der Ringnut 12 selbsttätig aus, da der Vorsprung 4 bis zum Anschlag an beide Seiten der Fläche 12a in die Ringnut gleitet.

Das erfindungsgemäße Substratträger-Adapter-System kann bei der ein- oder beidseitigen Beschichtung eines oder mehrerer Substrate zum Einsatz kommen. Insbesondere kann das erfindungsgemäße System bei der Beschichtung durch Kathodenzerstäubung verwendet werden, wobei die Wand 3 des Substratträgers als Anodenfläche dienen kann und zu diesem Zweck vorzugsweise aus einem geeigneten Metall oder Metallegierung besteht.

Das erfindungsgemäße Substratträger-Adapter-System kann als einheitliches und einziges Substratträger-Adapter-System während des gesamten Durchlaufs durch eine Anlage verwendet werden und auch bei anderen während des Prozesses erforderlichen Behandlungsschritten, z.B. einer Reinigung des Substrats, zum Einsatz kommen.

## Patentansprüche

1. Substratträger (1), insbesondere zur Aufnahme eines beidseitig zu behandelnden oder zu beschichtenden Substrats (13), mit
(a) einem Innenraum (2) zur Aufnahme mindestens eines Substrats (13),
(b) einer ringförmigen Wand (3), die sich senkrecht zur Mittelebene (M) des Substratträgers (1) erstreckt und den Innenraum (2) seitlich begrenzt,
(c) einem am Außenumfang (3a) der Wand (3) umlaufenden, konvexen Vorsprung (4), dessen Scheitelpunkt in der Mittelebene (M) liegt, und
(d) zwei symmetrisch zur Mittelebene (M) und zum Vorsprung (4) umlaufenden konkaven Nuten (5a, 5b) zum Eingriff mit mindestens einer Halte- und/oder Greifeinrichtung.

2. Substratträger (1) nach Anspruch 1, wobei das Substrat (13) durch mindestens zwei Substrathalter (14) an der Innenseite der Wand (3) gehalten wird.

3. Substratträger (1) nach Anspruch 1 oder 2, wobei die ringförmige Wand (3) kreiszylindrisch ausgebildet ist.

4. Substratträger (1) nach Anspruch 1 oder 2, wobei die Innenseite der ringförmigen Wand (3) konisch und die Außenseite der ringförmigen Wand (3) kreiszylindrisch ausgebildet ist.

5. Vorrichtung zum Handhaben des Substratträgers (1) nach einem der Ansprüche 1 bis 4, mit mindestens zwei passiven Haltevorrichtungen (6) zum Positionieren am Umfang des Substratträgers (1) mit jeweils einer Rolle (7), die durch eine Feder (8) gegen den Vorsprung (4) auf der einen Seite bezüglich der Mittelebene (M) gedrückt wird, und einer Anschlagfläche (6a), auf der eine Fläche (4a) des Vorsprungs (4) auf der anderen Seite bezüglich der Mittelebene (M) aufsitzt.

6. Vorrichtung nach Anspruch 5, wobei mindestens drei, vorzugsweise vier Haltevorrichtungen (6) zum Positionieren am Umfang des Substratträgers (1) vorgesehen sind.

7. Vorrichtung nach Anspruch 5 oder 6, wobei der Substratträger (1) in Richtung des Pfeiles (A) rollend oder gleitend über die Rolle (7) gedrückt wird, bis die Fläche (4a) auf der Anschlagfläche (6a) aufsitzt, wobei die Rolle (7) den Substratträger (1) in dieser Position federnd und mit definierter Kraft lösbar verriegelt.

8. Vorrichtung nach Anspruch 6 oder 7, wobei der Substratträger (1) durch die Haltevorrichtung (6) zentriert wird.

9. System, aus einem Substratträger (1) nach einem der Ansprüche 1 bis 4 und einer Vorrichtung zum Greifen des Substratträgers (1) mit mindestens zwei Greifeinrichtungen (9a oder 9b) zum Positionieren am Umfang des Substratträgers (1) mit jeweils einer Rolle (10), die in Eingriff mit einer der Nuten (5a, 5b) bringbar ist.

10. System nach Anspruch 9, wobei mindestens drei, vorzugsweise vier Greifeinrichtungen (9a oder 9b) zum Positionieren am Umfang des Substratträgers (1) vorgesehen sind.

11. System nach Anspruch 9 oder 10, wobei der Radius der Rolle (10) kleiner als der Radius der Nut (5a, 5b) ist, so daß beim Eingriff der Rolle (10) in die Nut (5a, 5b) der Substratträger (1) senkrecht zur Achse der Rolle (10) selbsttätig ausgerichtet wird.

12. Verfahren zum Handhaben eines Substratträgers (1) nach einem der Ansprüche 1 bis 4 mittels des Systems nach Anspruch 9, 10 oder 11, wobei die Greifeinrichtung (9a oder 9b) an den Substratträger (1) heranfährt und die Rolle (10) in die Nut (5a öder 5b) eingreift, die Greifeinrichtung (9a oder 9b) den Substratträger (1) transportiert und anschließend den Eingriff der Rolle (10) in der Nut (5a oder 5b) löst.

13. Verfahren nach Anspruch 12, wobei der Substratträger (1) mittels eines zweiten Systems nach Anspruch 9, 10 oder 11 ergriffen und nach Lösen der ersten Greifeinrichtung (9a) oder einer Haltevorrichtung (6) nach einem der Ansprüche 5 bis 8 von dem Substratträger (1) diesen übernimmt.

14. System aus einem Substratträger nach einem der Ansprüche 1 bis 4 und einer Vorrichtung zum Handhaben des Substratträgers (1) mit mehreren, vorzugsweise zwei Greifeinrichtungen zum Positionieren am Umfang des Substratträgers (1), die jeweils eine V-ftirnvge Ringnut (12) aufweisen, deren dem Substratträger (1) zugewandte Fläche (12a) den Vorsprung (4) auf der einen Seite und auf der anderen Seite bezüglich der Mittelebene tangiert, wobei der Substratträger (1) senkrecht zur Andruckrichtung (B) der Ringnut (12) selbsttätig ausgerichtet wird.

15. Verfahren zum Handhaben eines Substratträgers (1) nach einem der Ansprüche 1 bis 4 mittels des Systems nach Anspruch 14, wobei die Ringnut (12) in Radialrichtung (Pfeil B) von außen an den Substratträger (1) herangeführt und mit dem Vorsprung (4) in Eingriff gebracht wird, die Greifeinrichtung den Substratträger (1) transportiert und anschließend die Fläche (12a) in Radialrichtung nach außen von dem Vorsprung (4) entfernt.

16. Verwendung des Substratträgers (1) nach einem der Ansprüche 1 bis 4, der Vorrichtung nach einem der Ansprüche 5 bis 8, des Systems nach Anspruch 9, 10, 11 oder 14 und des Verfahrens nach Anspruch 12, 13 oder 15 bei der ein- oder beidseitigen Beschichtung des Substrats.

17. Verwendung nach Anspruch 16, bei der Beschichtung durch Kathodenzerstäubung.

18. Verwendung nach Anspruch 17, wobei die Wand (3) des Substratträgers (1) als Anodenfläche dient.

19. Verwendung nach Anspruch 16, bei CVD (chemical vapor deposition) Beschichtungsprozessen.

20. Verwendung des Substratträgers (1) nach einem der Ansprüche 1 bis 4, der Vorrichtung nach einem der Ansprüche 5 bis 8, des Systems nach Anspruch 9, 10, 11 oder 14 und des Verfahrens nach Anspruch 12, 13 oder 15 bei der Reinigung des Substrats.

## Claims

1. A substrate support (1), in particular for receiving a substrate (13) which should be treated or coated on both sides, comprising
(a) an internal space (2) for receiving at least one substrate (13),
(b) an annular wall (3) which extends vertically with respect to the center plane (M) of the substrate support (1) and limits the internal space (2) laterally,
(c) a convex projection (4) which extends on the outer circumference (3a) of the wall (3) and whose vertex lies in the center plane (M), and
(d) two circumferential concave grooves (5a, 5b) which extend symmetrically with respect to the center plane (M) and the projection (4) and serve for engaging at least one holding and/or gripping means.

2. The substrate support (1) according to claim 1, wherein the substrate (13) is held by at least two substrate holders (14) at the inner side of the wall (3).

3. The substrate support (1) according to claim 1 or 2, wherein the annular wall (3) has the shape of a circular cylinder.

4. The substrate support (1) according to claim 1 or 2, wherein the inner side of the annular wall (3) is conical and the outer side of the annular wall (3) has the shape of a circular cylinder.

5. A device for manipulating the substrate support (1) according to any one of claims 1 to 4, comprising at least two passive holding devices (6) for being positioned on the circumference of the substrate support (1), each comprising a roller (7) which is pressed by a spring (8) against the projection (4) on the one side with respect to the center plane (M), as well as a stopping surface (6a) on which a surface (4a) of the projection (4) rests on the other side with respect to the center plane (M).

6. The device according to claim 5, wherein at least three, preferably four holding devices (6) are provided for being positioned on the circumference of the substrate support (1).

7. The device according to claim 5 or 6, wherein the substrate support (1) is pressed in a rolling or sliding manner over the roller (7) in the direction of the arrow (A) until the surface (4a) rests on the stopping surface (6a), wherein the roller (7) detachably locks the substrate support (1) in said position in a spring-loaded manner and with a defined force.

8. The device according to claim 6 or 7, wherein the substrate support (1) is centered by means of the holding device (6).

9. A system consisting of a substrate support (1) according to any one of claims 1 to 4 and a device for gripping the substrate support (1), comprising at least two gripping means (9a or 9b) for positioning on the circumference of the substrate support (1) and having one roller (10) each, which can be engaged with one of the grooves (5a, 5b).

10. The system according to claim 9, wherein at least three, preferably four gripping means (9a or 9b) are provided for positioning on the circumference of the substrate support (1).

11. The system according to claim 9 or 10, wherein the radius of the roller (10) is smaller than the radius of the groove (5a, 5b) so that the substrate support (1) is automatically aligned vertically with respect to the axis of the roller (10) when the roller (10) engages with the groove (5a, 5b).

12. A method for manipulating a substrate support (1) according to any one of claims 1 to 4 by means of the system according to claim 9, 10 or 11, wherein the gripping means (9a or 9b) approaches the substrate support (1) and the roller (10) engages with the groove (5a or 5b), the gripping means (9a or 9b) transports the substrate support (1) and then releases the engagement of the roller (10) with the groove (5a or 5b).

13. The method according to claim 12, wherein the substrate support (1) is gripped by means of a second system according to claim 9, 10 or 11 and, after the first gripping means (9a) or a holding device (6) according to any one of claims 5 to 8 is released from the substrate support (1),takes over said substrate support (1).

14. A system consisting of a substrate support according to any one of claims 1 to 4 and a device for manipulating the substrate support (1), comprising a plurality, preferably two gripping means for positioning on the circumference of the substrate support (1) and each having a V-shaped annular groove (12) whose surface (12a) facing the substrate support (1) tangentially touches the projection (4) on the one side and on the other side with respect to the center plane, wherein the substrate support (1) is automatically aligned vertically with respect to the pressing-on direction (B) of the annular groove (12).

15. A method for manipulating a substrate support (1) according to any one of claims 1 to 4 by means of the system according to claim 14, wherein the annular groove (12) is moved from the outside towards the substrate support (1) in the radial direction (arrow B) and is engaged with the projection (4), the gripping means transports the substrate support (1) and subsequently removes the surface (12a) from the projection (4) in the radial direction towards the outside.

16. Use of the substrate support (1) according to any one of claims 1 to 4, the device according to any one of claims 5 to 8, the system according to claim 9, 10, 11 or 14 and the method according to claim 12, 13 or 15 for coating the substrate on one side or both sides.

17. Use according to claim 16 for coating by means of cathode sputtering.

18. Use according to claim 17, wherein the wall (3) of the substrate support (1) serves as an anode surface.

19. Use according to claim 16 in CVD (chemical vapor deposition) coating processes.

20. Use of the substrate support (1) according to any one of claims 1 to 4, the device according to any one of claims 5 to 8, the system according to claim 9, 10, 11 or 14 and the method according to claim 12, 13 or 15 for cleaning the substrate.

## Revendications

1. Support de substrat (1), en particulier pour la réception d'un substrat (13) à traiter ou à revêtir des deux côtés, avec
(a) un espace intérieur (2) pour la réception d'au moins un substrat (13),
(b) une paroi annulaire (3) qui s'étend perpendiculairement au plan médian (M) du support de substrat (1) et qui délimite l'espace intérieur (2) latéralement,
(c) une saillie convexe (4) s'étendant au pourtour extérieur (3a) de la paroi (3), dont le sommet se situe dans le plan médian (M), et
(d) deux rainures concaves circonférentielles (5a, 5b) s'étendant symétriquement au plan (M) et à la saillie (4) pour la mise en prise avec au moins une installation de retenue et/ou de préhension.

2. Support de substrat (1) selon la revendication 1, où le substrat (13) est tenu par au moins deux porte-substrats (14) au côté intérieur de la paroi (3).

3. Support de substrat (1) selon la revendication 1 ou 2, où la paroi annulaire (3) est réalisée en une forme cylindrique circulaire.

4. Support de substrat (1) selon la revendication 1 ou 2, où le côté intérieur de la paroi annulaire (3) est réalisé en une forme conique et le côté extérieur de la paroi annulaire (3) en une forme circulaire cylindrique.

5. Dispositif de manipulation du support de substrat (1) selon l'une des revendications 1 à 4, avec au moins deux dispositifs de retenue passifs (6) pour le positionnement au pourtour du support de substrat (1) avec respectivement un galet (7) qui est poussé par un ressort (8) contre la saillie (4) sur un côté relativement au plan médian (M), et une face de butée (6a) sur laquelle repose une face (4a) de la saillie (4) sur l'autre côté relativement au plan médian (M).

6. Dispositif selon la revendication 5, où sont prévus au moins trois, de préférence quatre dispositifs de retenue (6) pour le positionnement au pourtour du support de substrat (1).

7. Dispositif selon la revendication 5 ou 6, où le support de substrat (1) est poussé dans la direction de la flèche (A), en roulant ou en glissant sur le galet (7) jusqu'à ce que la face (4a) repose sur la face de butée (6a), où le galet (7) verrouille relâchablement le support de substrat (1) dans cette position d'une manière élastique et avec une force définie.

8. Dispositif selon la revendication 6 ou 7, où le support de substrat (1) est centré par le dispositif de retenue (6).

9. Système formé par un support de substrat (1) selon l'une des revendications 1 à 4 et un dispositif de préhension du support de substrat (1) avec au moins deux installations de préhension (9a ou 9b) pour le positionnement au pourtour du support de substrat (1) avec respectivement un galet (10), qui peut être mis en prise avec l'une des rainures (5a, 5b).

10. Système selon la revendication 9, où sont prévues au moins trois, de préférence quatre installations de préhension (9a ou 9b) pour le positionnement au pourtour du support de substrat (1).

11. Système selon la revendication 9 ou 10, où le rayon du galet (10) est plus petit que le rayon de la rainure (5a, 5b) de sorte que lors de l'engagement du galet (10) dans la rainure (5a, 5b), le support de substrat (1) est orienté automatiquement perpendiculairement à l'axe du galet (10).

12. Procédé de manipulation d'un support de substrat (1) selon l'une des revendications 1 à 4 au moyen du système selon la revendication 9, 10 ou 11, où l'installation de préhension (9a ou 9b) s'approche du support de substrat (1), et le galet (10) s'engage dans la rainure (5a ou 5b), l'installation de préhension (9a ou 9b) transporte le support de substrat (1) et met ensuite hors prise le galet (10) avec la rainure (5a ou 5b).

13. Procédé selon la revendication 12, où le support de substrat (1) est saisi au moyen d'un deuxième système selon la revendication 9, 10 ou 11 et, après le relâchement de la première installation de préhension (9a), ou d'un dispositif de retenue (6) selon l'une des revendications 5 à 8 du support de substrat (1), prend en charge celui-ci.

14. Système formé par un support de substrat selon l'une des revendications 1 à 4 et un dispositif de manipulation du support de substrat (1) avec plusieurs, de préférence deux installations de préhension pour le positionnement au pourtour du support de substrat (1) qui présentent respectivement une rainure annulaire en forme de V (12), dont la face (12a) orientée vers le support de substrat (1) vient en contact avec la saillie (4) sur un côté et sur l'autre côté relativement au plan médian, où le support de substrat (1) est orienté automatiquement perpendiculairement à la direction d'application (B) de la rainure d'annulaire (12).

15. Procédé de manipulation d'un support de substrat (1) selon l'une des revendications 1 à 4 au moins du système selon la revendication 14 où la rainure annulaire (12) est amenée dans la direction radiale (flèche B) depuis l'extérieur au support de substrat (1) et est mise en prise avec la saillie (4), l'installation de préhension transporte le support de substrat (1) et éloigne ensuite la face (12a) dans la direction radiale vers l'extérieur de la saillie (4).

16. Utilisation du support de substrat (1) selon l'une des revendications 1 à 4, du dispositif selon l'une des revendications 5 à 8, du système selon la revendication 9, 10, 11 ou 14 et du procédé selon la revendication 12, 13 ou 15 lors du revêtement d'un côté ou des deux côtés du substrat.

17. Utilisation selon la revendication 16, lors du revêtement par pulvérisation cathodique.

18. Utilisation selon la revendication 17, où la paroi (3) du support de substrat (1) sert de face d'anode.

19. Utilisation selon la revendication 16, dans des procédés de revêtement CVD (dépôt chimique en phase vapeur).

20. Utilisation du support de substrat (1) selon l'une des revendications 1 à 4, du dispositif selon l'une des revendications 5 à 8, du système selon la revendication 9, 10, 11 ou 14 et du procédé selon la revendication 12, 13 ou 15 lors du nettoyage du substrat.
